(19) Europäisches Patentamt / European Patent Office / Office européen des brevets

(11) **EP 2 592 667 B1**

(12) **FASCICULE DE BREVET EUROPEEN**

(45) Date de publication et mention
de la délivrance du brevet:
**14.05.2014 Bulletin 2014/20**

(51) Int Cl.:
*H01L 35/16* [(2006.01)]    *H01L 35/26* [(2006.01)]

(21) Numéro de dépôt: **12191997.1**

(22) Date de dépôt: **09.11.2012**

(54) **Matériau composite hybride thermoélectrique**

Thermoelektrisches Hybridverbundmaterial

Thermoelectric hybrid composite material

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **10.11.2011 FR 1160289**

(43) Date de publication de la demande:
**15.05.2013 Bulletin 2013/20**

(73) Titulaires:
- **ACOME Société coopérative et participative Société
anonyme coopérative de production à capital variable
75014 Paris (FR)**
- **Université Montpellier 2, Sciences et Techniques
34090 Montpellier (FR)**

(72) Inventeurs:
- **Papavero, Amory
34000 Montpellier (FR)**
- **Ait Ameur, Mehdi
50140 Romagny (FR)**
- **Tedenac, Jean-Claude
34070 Montpellier (FR)**
- **Cornu, David
34270 Les Matelles (FR)**

(74) Mandataire: **Cabinet Plasseraud
52, rue de la Victoire
75440 Paris Cedex 09 (FR)**

(56) Documents cités:
WO-A1-2009/150690    WO-A2-2010/117875
JP-A- 8 032 124    US-A- 5 973 050
US-A1- 2006 118 158    US-A1- 2010 258 154

US-B2- 6 759 587

- GUERRERO V H ET AL: "Thermoelectric property tailoring by composite engineering", JOURNAL OF MATERIALS SCIENCE, SPRINGER NETHERLANDS, NL, vol. 37, no. 19, 1 octobre 2002 (2002-10-01), pages 4127-4136, XP002505017, ISSN: 0022-2461, DOI: 10.1023/A:1020083718789
- CHATTERJEE K ET AL: "Synthesis and characterization of an electro-deposited polyaniline-bismuth telluride nanocomposite - A novel thermoelectric material", MATERIALS CHARACTERIZATION, ELSEVIER, NEW YORK, NY, US, vol. 60, no. 12, 1 décembre 2009 (2009-12-01), pages 1597-1601, XP026737329, ISSN: 1044-5803, DOI: 10.1016/J.MATCHAR.2009.09.012 [extrait le 2009-09-27]
- DASAROYONG KIM ET AL: "Improved Thermoelectric Behavior of Nanotube-Filled Polymer Composites with Poly(3,4-ethylenedioxythiophene) Poly (styrenesulfonate)", ACS NANO, vol. 4, no. 1, 26 janvier 2010 (2010-01-26), pages 513-523, XP055028192, ISSN: 1936-0851, DOI: 10.1021/nn9013577
- HEWITT C ET AL: "Varying the concentration of single walled carbon nanotubes in thin film polymer composites, and its effect on thermoelectric power", APPLIED PHYSICS LETTERS, AIP, AMERICAN INSTITUTE OF PHYSICS, MELVILLE, NY, US, vol. 98, no. 18, 5 mai 2011 (2011-05-05), pages 183110-183110, XP012140571, ISSN: 0003-6951, DOI: 10.1063/1.3580761

- CAILLAT T ET AL: "Study of the Bi-Sb-Te ternary phase diagram", JOURNAL OF PHYSICS AND CHEMISTRY OF SOLIDS, PERGAMON PRESS, LONDON, GB, vol. 53, no. 2, 1 février 1992 (1992-02-01), pages 227-232, XP024508986, ISSN: 0022-3697, DOI: 10.1016/0022-3697(92)90049-J [extrait le 1992-02-01]

- L. D. IVANOVA ET AL: "Extruded thermoelectric materials based on Bi2Te3-Bi2Se3 solid solutions", INORGANIC MATERIALS, vol. 45, no. 2, 1 février 2009 (2009-02-01), pages 123-128, XP055030498, ISSN: 0020-1685, DOI: 10.1134/S0020168509020034

**Description**

La présente invention concerne un matériau composite hybride thermoélectrique, un procédé d'obtention dudit matériau composite hybride thermoélectrique ainsi que ses utilisations.

L'effet thermoélectrique est un phénomène physique présent dans certains matériaux qui lie le flux de chaleur qui les traverse au courant électrique qui les parcourt. Ainsi un matériau thermoélectrique va permettre de transformer directement de la chaleur en électricité (effet Seebeck), ou inversement de générer de la chaleur par l'application d'un champ électrique (effet Peltier).

Un matériau thermoélectrique est caractérisé par sa figure de mérite définie de la manière suivante :

$$ZT = \frac{\alpha^2 T}{\rho \lambda}$$

Où $\alpha$ est le coefficient de Seebeck (V.K$^{-1}$)
p est la résistivité électrique ($\Omega$.m)
$\lambda$ est la conductivité thermique (W.m$^{-1}$.K$^{-1}$)

Un bon matériau thermoélectrique est un matériau qui présente une figure de mérite élevée, autrement dit il s'agit d'un matériau présentant un coefficient de Seebeck élevé, une résistivité électrique faible ainsi qu'une conductivité thermique faible. Tout l'enjeu réside donc dans le fait de trouver un bon compromis entre ces facteurs.

Depuis plusieurs décennies, les modules à effet Peltier/Seebeck sont constitués de couples de jambes thermoélectriques connectés électriquement par un matériau conducteur. Chaque couple comprend une jambe d'un matériau semi-conducteur de type p et une jambe d'un matériau semi-conducteur de type n.

Bien que ces modules soient largement utilisés, ils présentent de nombreux inconvénients. En effet, les semi-conducteurs de type p ou n sont utilisés sous leur forme massive (frittés, polycristal ou monocristal). Or, ces matériaux massifs sont couteux et difficiles à mettre en forme. De plus, ils sont fragiles, il est donc impossible de les intégrer dans des structures de grandes tailles. Enfin, les propriétés thermoélectriques des matériaux massifs sont optimales mais sont moins intéressantes pour certaines applications que celles de matériaux dispersés, sous forme de poudre par exemple.

C'est pourquoi, depuis quelques années, on assiste à un renouveau important des recherches scientifiques dédiées à ces matériaux thermoélectriques visant à trouver de nouvelles structures performantes, économiques et faciles à mettre en oeuvre.

Ainsi, un compromis entre de bonnes propriétés thermoélectriques et de bonnes propriétés mécaniques est recherché.

A titre d'exemple, on peut citer le document US 6710238 qui décrit un matériau thermoélectrique composé d'un ensemble de multicouches ou bien le document US 2008/087314 qui présente un matériau nanocomposite thermoélectrique comprenant des nanoparticules enrobées qui sont consolidées entre elles par diverses techniques.

Les matériaux thermoélectriques décrits dans les documents précédemment cités présentent une structure complexe et sont, par conséquent, difficiles à mettre en oeuvre.

Par ailleurs, la demande de brevet WO2010/117875 décrit un matériau composite thermoélectrique triphasique comprenant une résine, des particules thermoélectriques dispersées dans ladite résine, et des particules métalliques entourant la surface des particules thermoélectriques.

Cependant, malgré la présence de particules métalliques, ce matériau composite thermoélectrique triphasique présente une très faible figure de mérite.

Enfin, on peut citer les documents JP8032124 et US 6759587 qui décrivent des matériaux composites comprenant une matrice polymère et des charges thermoélectriques p ou n dispersées dans ladite matrice. Cependant dans ces documents, afin d'améliorer les propriétés thermoélectriques, le matériau subit un traitement thermique dans lequel la matrice polymère est soit retirée par l'utilisation d'un solvant pour solubiliser le polymère, soit dégradée altérant non seulement les propriétés mécaniques (souplesse, flexibilité...) mais conduisant également à des procédés plus coûteux (mise en forme complexe) et moins respectueux de l'environnement (solvants). Dans les documents précités, le polymère et/ou le solvant ne jouent pas un rôle de mise en forme et tous les traitements dégradent le matériau et altèrent ses propriétés de transport.

Il existe donc un réel besoin en un matériau thermoélectrique qui présente non seulement une figure de mérite du même ordre de grandeur que les matériaux monophasiques massifs, mais aussi qui présente de bonnes propriétés mécaniques lui conférant ainsi une bonne aptitude à la mise en forme afin de pouvoir les intégrer dans des structures de grande taille.

Or, la Demanderesse a découvert qu'un matériau composite hybride thermoélectrique à matrice polymère permettait de répondre à ces exigences.

Ainsi, un objet de l'invention est un matériau composite hybride thermoélectrique comprenant :

- une matrice polymère ;
- des charges thermoélectriques sous forme de particules dispersées au sein de la matrice polymère ;

dans lequel ledit matériau composite hybride est dépourvu de particules métalliques et les charges thermoélectriques sont des alliages multicomposants semi-conducteurs de type p ou de type n comprenant au moins les éléments Bi et Te, caractérisé par le fait que la matrice polymère comprend au moins un polymère choisi dans le groupe consistant en le polystyrène (PS), le polychlorure de vinyle (PVC), le polyéthylène (PE), le polyfluorure de vinylidène (PVDF), le poly(méthyl méthacrylate) (PMMA), le poly vinyl acétate (PVA), le polyimide (PI), le polypropylène (PP), et leurs mélanges.

Selon un autre mode de réalisation, la matrice polymère est un copolymère afin d'augmenter les propriétés mécaniques du matériau composite hybride. A titre d'exemple, on peut citer les copolymères suivants: le polyéthylène (PE)/ poly(méthyl méthacrylate)(PMMA), le polyéthylène (PE)/ poly vinyl acétate (PVA), le polystyrène (PS)/ polypropylène (PP) et leurs mélanges.

Selon un autre mode de réalisation, la matrice polymère est composée d'au moins un polymère et au moins un copolymère tels que décrits précédemment.

Selon un autre mode de réalisation combiné aux précédents, la matrice polymère comprend en outre du plastisol (dispersion d'un polymère dans un plastifiant).

Par matériau composite, on entend un matériau comprenant au moins deux matériaux non miscibles tels que la matrice polymère et les charges thermoélectriques.

Par matériau hybride, on entend un matériau qui comprend à la fois au moins un composé organique (matrice polymère) et au moins un composé inorganique (charges thermoélectriques).Ainsi, selon l'invention, le matériau étant un matériau hybride, la matrice polymère reste organique et n'est pas dégradée conférant ainsi une bonne tenue thermomécanique du matériau thermoélectrique de l'invention.

Par matériau thermoélectrique, on entend un matériau permettant de convertir un flux de chaleur en puissance électrique ou inversement.

Par alliage multicomposants, on entend un composé qui est constitué de trois ou plus éléments chimiques dont au moins un élément est un métal. Selon l'invention, la matrice polymère comporte au moins un polymère et/ou un copolymère.

On utilisera indifféremment les termes de « matériau composite hybride thermoélectrique »ou « matériau composite hybride ».

Selon un mode de réalisation, lorsque le matériau composite hybride contient des charges thermoélectriques de type p, il s'agit d'alliages multicomposants semi-conducteurs contenant au moins les éléments Bi, Sb et Te. Selon un autre mode de réalisation, lorsque le matériau composite hybride contient des charges thermoélectriques de type n, il s'agit d'alliages multicomposants semi-conducteurs contenant au moins les éléments Bi, Te et Se.

Selon l'invention, les alliages multicomposants semiconducteurs (type p ou type n) ont un faible gap. En d'autres termes, les bandes de valence et de conduction sont très proches l'une de l'autre. Ce faible gap est obtenu en modifiant la formulation chimique des alliages multicomposants, c'est-à-dire en ajustant les quantités relatives des éléments constitutifs. En d'autres termes, la stoechiométrie des alliages multicomposants influe fortement sur les propriétés semi-conductrices des alliages multicomposants et ainsi sur les propriétés thermoélectriques du matériau composite hybride de l'invention.

Ainsi, selon un mode de réalisation particulier de l'invention, le matériau composite hybride contenant des charges thermoélectriques de type p, est un alliage de formule $Bi_uSb_vTe_w$, où u, v et w sont définis par lés relations suivantes :

- $50 \leq w \leq 60$, de préférence $55 \leq w \leq 60$, encore plus préférentiellement w=60, et
- $3b \leq u+v \leq 40$, de préférence $35 \leq u+v \leq 40$, encore plus préférentiellement u+v=40

Selon un autre mode de réalisation particulier de l'invention, le matériau composite hybride contenant des charges thermoélectriques de type n, est un alliage de formule $Bi_xTe_ySe_z$, où x, y et z sont définis par les relations suivantes:

- $30 \leq x \leq 40$, de préférence $35 \leq x \leq 40$, encore plus préférentiellement x=40
- $50 \leq y+z \leq 60$, de préférence $55 \leq y+z \leq 60$, encore plus préférentiellement y+z=60

Selon un mode de réalisation particulierde l'invention, lorsque le matériau composite hybride contient des charges thermoélectriques de type p ; alors u, v et w sont définis de la manière suivante : u=8, v=32, w=60. Autrement dit les charges thermoélectriques de type p sont des alliages multicomposants de $Bi_8Sb_{32}Te_{60}$.

Selon un autre mode de réalisation particulier, lorsque le matériau composite hybride contient des charges thermoélectriques de type n ; alors x, y et z sont définis de la manière suivante : x=40, y=42 et z=18. Autrement dit les charges thermoélectriques de type n sont des alliages multicomposants de $Bi_{40}Te_{42}Se_{18}$.

Selon un mode de réalisation commun aux modes de réalisation décrits précédemment, les alliages multicomposants de type n ou de type p comprennent en outre un élément dopant D ayant pour fonction l'amélioration des propriétés de transport électronique.

Cet élément dopant est sélectionné selon différents critères tels que sa solubilité au sein du matériau thermoélectrique composite hybride, son activité électrique ou bien encore selon sa stabilité à des températures supérieures aux températures classiques d'utilisation de tels matériaux thermoélectriques.

Il existe deux grandes classes de dopants bien connues de l'homme du métier : les donneurs et les accepteurs.

A titre d'exemple, on peut citer comme exemple d'atome(s) donneur(s) le chlore, le brome ; les métaux comme le cuivre, l'argent et le cadmium ; les halogénures comme CuBr, $CdBr_2$, etc...

Les atomes accepteurs peuvent être par exemple les atomes du groupe IV comme l'étain, le plomb et le germanium ; des semi-métaux comme l'arsenic, l'antimoine ou le bismuth, etc...

Lorsque le matériau composite hybride de l'invention comprend un élément dopant, celui-ci est introduit en très faible quantité (typiquement 1 pour 1000 ou 1 pour 10000 en poids).

Selon un autre mode de réalisation, le matériau composite hybride comprend en outre des charges supplémentaires telles que des nanotubes de carbone, des billes de verre ou du noir de carbone afin d'améliorer les propriétés thermoélectriques du matériau composite hybride.

Les propriétés physiques et mécaniques du matériau composite hybride thermoélectrique de l'invention dépendent notamment du taux de charges thermoélectriques dans le matériau composite hybride.En effet, un compromis entre de bonnes propriétés thermoélectriques et une bonne tenue thermomécanique est recherché.

Ainsi, à taux de charge faible (inférieur à 10%), le matériau composite hybride présente une figure de mérite nulle (résistivité électrique très élevée, conductivité thermique faible et coefficient de Seebeck nul).

A l'inverse, à taux de charge élevé (supérieur à 99%) le matériau composite hybride présente une figure de mérite élevée (résistivité électrique faible, conductivité thermique élevée et coefficient de Seebeck élevé). Cependant, sa tenue thermomécanique est un peu moins bonne.

Ainsi, selon l'invention, le pourcentage volumique des particules de charges thermoélectriques est compris entre 10 à 99%, de préférence entre 40 et 90% et encore plus préférentiellement entre 50 et 70% du volume total du matériau composite hybride.

Selon l'invention, il est important que les charges thermoélectriques présentent une distribution de taille de particules homogène. Ainsi, le diamètre des particules des charges thermoélectriques est compris entre 50nm et 500$\mu$m de préférence entre 1$\mu$m et 300$\mu$m et encore plus préférentiellement entre 1$\mu$m et 150$\mu$m. Le diamètre des particules des charges thermoélectriques a été mesuré pargranulométrie laser et par échantillonnage au Microscope Electronique à Balayage (MEB).

Des tests effectués par la Demanderesse ont démontré par des mesures de résistivité électrique, de conductivité thermique et du coefficient de Seebeck que le matériau composite hybride thermoélectrique de l'invention présente une figure de mérite ZT supérieure à 0,1, de préférence supérieure à 0,2 et encore plus préférentiellement supérieure à 0,3.

Un autre objet de l'invention concerne un procédé d'obtention du matériau composite hybride tel que défini précédemment comprenant les étapes suivantes :

(i) synthèse des charges thermoélectriques sous forme de particules;
(ii) mélange des particules obtenues à l'étape (i) avec un polymère et/ou copolymère;
(iii) mise en forme du mélange obtenu à l'étape (ii).

Selon un mode de réalisation, les charges thermoélectriques sous forme de particules sont mélangées lors de l'étape (ii) avec un polymère choisi dans le groupe consistant en le polystyrène (PS), le polychlorure de vinyle (PVC), le polyéthylène (PE), le polyfluorure de vinylidène (PVDF), le poly(méthyl méthacrylate) (PMMA), le poly vinyl acétate (PVA), le polyimide (PI), le polypropylène (PP), et leurs mélanges.

Selon un autre mode de réalisation, les charges thermoélectriques sous forme de particules sont mélangées lors de l'étape (ii) avecun copolymère afin d'augmenter les propriétés mécaniques du matériau composite hybride. A titre d'exemple, on peut citer les copolymères suivants: le polyéthylène (PE) / poly(méthyl méthacrylate)(PMMA), le polyéthylène (PE)/ poly vinyl acétate (PVA), le polystyrène (PS)/ polypropylène (PP) et leurs mélanges.

Selon un mode de réalisation, la synthèse des charges thermoélectriques comprend les étapes suivantes :

- mélange d'une quantité donnée des éléments Bi, Sb, Te ou Bi, Te, Se et d'un éventuel dopant D en fonction d'une stoechiométrie visée ;
- traitement thermique du mélange afin d'atteindre la fusion desdits éléments ;
- refroidissement dudit mélange ;
- obtention d'une poudre par broyage ;
- éventuellement un recuit des poudres.

Selon l'invention, la synthèse est réalisée sous un environnement contrôlé, par exemple, sous argon ou sous vide.

Selon un mode de réalisation, le traitement thermique est réalisé à une température comprise entre 20 et 800°C. La température du traitement thermique peut être maintenue pendant une durée comprise typiquement entre 2h et 48h.

Le broyage pouvant être réalisé dans un broyeur planétaire peut être précédé d'un broyage manuel afin d'obtenir des granules de quelques millimètres.

Les granules obtenues après le broyage manuel sont ensuite introduites dans des bols en acier avec des billes de broyage. Typiquement, le ratio billes de broyage/granules et de 2/1 en poids.

Afin d'éviter toute oxydation, le broyage est réalisé sous un environnement contrôlé, par exemple, sous argon.

L'homme du métier saura fixer les paramètres de broyage tels que la vitesse de rotation du broyeur planétaire ou la durée du broyage selon la taille des particules souhaitée.

A titre d'exemple, la vitesse de rotation est comprise entre 150 et 300 tours/min et la durée du broyage est comprise entre 30 minutes et deux heures.

Le broyage peut être suivi par un tamisage des poudres afin de sélectionner une taille maximale de particules.

La poudre issue du broyage peut ensuite subir un recuit afin d'améliorer les propriétés de transport des poudres post-broyage. La température de recuit des poudres est ainsi comprise entre 100 et 300 °C.

Selon un mode de réalisation, les charges thermoélectriques se trouvent sous la forme de particules et le(s) polymère(s) et/ou copolymère(s) se trouvent sous la forme de solution ou sous la forme de particules. Selon un mode de réalisation préféré, les charges thermoélectriques et le(s) polymère(s) et/ou copolymère(s) se trouvent sous la forme de particules.

Selon un autre mode de réalisation, les particules de charges thermoélectriques et de polymère et/ou copolymère sont mélangés à l'aide d'une table vibrante afin d'homogénéiser le mélange.

Selon l'invention, la mise en forme du mélange peut être réalisée selon différentes techniques telles que l'enduction, le calandrage ou le pressage à chaud.

Selon un mode de réalisation préféré, la mise en forme du mélange est réalisée par pressage à chaud et comporte les étapes suivantes:

- introduction du mélange obtenu à l'issue de l'étape (ii) dans une matrice de pressage;
- montée en température dudit mélange pour atteindre une température T1;
- augmentation de la pression P dans la matrice de pressage ;
- maintien de la température T1 et de la pression P pendant une durée t ;
- descente en température à une température T2 en maintenant la pression P ;
- diminution de la pression jusqu'à la pression atmosphérique ;
- démoulage de la matrice de pressage.

Selon l'invention, la température T1 est supérieure à la température de transition vitreuse de la matrice polymèreet nécessairement inférieure à la température de dégradation de la matrice polymère afin d'obtenir un matériau thermoélectrique composite hybride. En effet, le fait que la matrice polymère reste organique après la mise en forme permet de conférer de bonnes propriétés mécaniques au matériau thermoélectrique, pouvant être mis en forme sous forme de bandes par exemple.

Typiquement, T1 est compris entre 50 et 300°C, de préférence entre 100°C et 200°C.

La montée en température peut être contrôlée par un régulateur. La rampe de température peut être comprise entre 1°C/min et 100°C/min, de préférence entre 5°C/min et 50°C/min.

Selon un mode de réalisation, la pression P est comprise entre 10MPa et 1GPa, de préférence entre 100MPa et 500MPa.

Selon l'invention, la pression P et la température T1 sont maintenues pendant une durée t comprise entre 1 minute et 1 heure, de préférence entre 5 minutes et 30 minutes.

La descente en température peut être réalisée avec ou sans contrôle extérieur, c'est-à-dire soit en imposant une rampe de refroidissement soit en laissant la matrice de pressage se refroidir naturellement jusqu'à atteindre la température T2 qui se situe autour de la température ambiante.

Par température ambiante, on entend une température comprise entre 20°C et 25°C.

Après l'étape de démoulage, en fonction de la forme initiale de la matrice de pressage, le matériau composite hybride de l'invention se trouve sous diverses formes telles qu'une pastille ou bien une bande.

Lorsque la mise en forme du matériau thermoélectrique est réalisée par pressage à chaud (sous forme de bande par exemple), il y a création d'un réseau percolant dans lequel les particules de charges thermoélectriques de type p ou de type n sont accolées les unes aux autres permettant ainsi d'améliorer les propriétés de conductivité électrique. L'amélioration de la conductivité électrique est un élément capital car ce paramètre améliore les valeurs du facteur de mérite (ZT). En effet, le phénomène de percolation permet d'améliorer les valeurs du facteur de mérite et de contrebalancer la baisse de ces mêmes valeurs de facteur de mérite (conductivité notamment) due à l'introduction du polymère (nécessaire pour conférer une bonne tenue thermomécanique).

Selon un mode de réalisation préféré de l'invention, le matériau composite hybride de l'invention se trouve sous la forme d'une bande qui grâce à la nature des matériaux utilisés présente de bonnes propriétés de souplesse et de flexibilité. Les bandes peuvent être ainsi intégrées dans des structures thermoélectriques de grandes tailles, par exemple de taille métrique.

En effet, contrairement aux jambes traditionnelles (semi-conducteur type p ou type n) dans lesquelles les trois dimensions sont en mm, le matériau composite hybride thermoélectrique, lorsqu'il est mis en forme sous la forme de bande, permet de réaliser des jambes thermoélectriques dont les trois dimensions sont de grandeurs différentes (par exemple,longueur en « cm », épaisseur en « mm » et largeur en « m »).

Le matériau composite hybride thermoélectrique de l'invention décrit précédemment ou le matériau composite hybride thermoélectrique obtenu selon le procédé décrit précédemment présente de nombreux avantages liés à sa figure de mérite importante (c'est-à-dire supérieure à 0,1) et à ses propriétés mécaniques lui conférant ainsi une bonne aptitude de mise en forme.

Il est ainsi parfaitement approprié à être utilisé dans des applications faisant appel aux effets Peltier ou Seebeck.

Ainsi un autre objet de l'invention concerne l'utilisation du matériau composite hybride thermoélectrique décrit précédemment dans la réalisation de panneaux composites hybrides thermoélectriques de faible densité de puissance en vue d'applications en chauffage et rafraîchissement de bâtiments.

La présente invention est illustrée avec les exemples suivants.

**[Exemples]**

Dans les exemples suivants, les abréviations suivantes sont utilisées :

- PS désigne la matrice polymère polystyrène
- %vol désigne le pourcentage volumique de charges thermoélectriques au sein du matériau composite hybride
- type p désigne le semiconducteur de type p : $Bi_8Sb_{32}Te_{60}$
- type n désigne le semiconducteur de type n : $Bi_{40}Te_{42}Se_{18}$
- les poudres désignent les poudres des semiconducteurs de type p et de type n post broyage.

**Exemple 1 Obtention du matériau composite thermoélectriquecontenant des charges thermoélectriques de type p ou de type n**

Dans cette partie expérimentale, 3 matériaux composites hybrides ont été préparés selon un taux de charges thermoélectriques (type p ou type n) différent :

- Matériau thermoélectrique composite hybride 1 : PS chargé à 40%vol de charges thermoélectriques de type p
- Matériau thermoélectrique composite hybride 2 : PS chargé à 60%vol de charges thermoélectriques de type p
- Matériau thermoélectrique composite hybride 3 : PS chargé à 70%vol de charges thermoélectriques de type n

*Charges thermoéléctriques (type p)*

Les éléments bismuth (Bi), antimoine (Sb), tellure (Te), purs à 99% sont introduits sous forme de grenailles ou concassés de quelques millimètres dans des tubes de quartz dans les proportions stoechiométriques, scellés sous vide secondaire (typiquement $5.10^{-4}$ Pa).

*Charges thermoéléctriques (type n)*

Les éléments bismuth (Bi), tellure (Te) et sélénium (Se), purs à 99% sont introduits sous forme de grenailles ou concassés de quelques millimètres dans des tubes de quartz dans les proportions stoechiométriques, scellés sous vide secondaire (typiquement $5.10^{-4}$ Pa).

Une fois scellés, les tubes sont placés dans des fours à moufles pour y subir le traitement thermique suivant (identique pour les deux types de charges thermoélectriques : type p ou type n) :

- montée en température selon une rampe de 60°C/heure
- palier à 700°C pendant 24 heures
- descente dite « naturelle » en température, sans contrôle d'un régulateur.

Les lingots de semiconducteur de type p et de type n obtenus en sortie de four sont ensuite broyés au sein d'un broyeur planétaire (FRITSCH GmbH) : les lingots sont d'abord réduits « à la main » en granules de quelques millimètres, puis introduits dans des bols en acier avec des billes de broyages (ratio billes/granules de 2/1 en poids). Le broyage s'effectue sous argon pour limiter l'oxydation des poudres, les bols sont donc fermés en boite à gants.
Le broyage dure 60 minutes à une vitesse de rotation de 250 tours par minute.
Les poudres sont ensuite tamisées sur un tamis vibrant afin de ne retenir que les poudres ayant un diamètre maximum de 45 $\mu$m.
Les poudres sont ensuite mélangées au PS (manufacturé par GoodFellow) dans les bonnes proportions selon le taux de charges souhaité dans le matériau composite hybride (matériaux composites hybrides 1-3), le tout étant homogénéisé sur table vibrante pendant 10 minutes. Le mélange poudre/PS ainsi obtenu est placé au sein d'une matrice acier, elle-même placée dans une presse à chaud uniaxiale, pour y subir le traitement thermique suivant :

- montée en température selon une rampe de 10°C/minute
- palier à 200°C pendant 5 minutes, avec mise en pression (typiquement 350 MPa), c'est-à-dire à une température inférieure à la température de dégradation de la matrice polymère ;
- descente dite « naturelle » en température, sans contrôle d'un régulateur tout en maintenant la pression à 350MPa ;
- diminution de la pression jusqu'à la pression atmosphérique.
- démoulage de la matrice de pressage.

Après démoulage, on obtient une pastille composite hybride de 13mm de diamètre sur quelques millimètres (typiquement 1 à 5) de hauteur.

## Exemple 2 Caractérisation des matériaux thermoélectriques composites hybrides (type p et type n)

Les pastilles obtenues à l'issue de l'exemple 1 sont découpées puis analysées suivant plusieurs directions afin de s'assurer de l'isotropie des propriétés physiques.
La figure de mérite ZT est déterminée en mesurant indépendamment la résistivité électrique (p), la conductivité thermique ($\lambda$) et le coefficient de Seebeck ($\alpha$). La figure de mérite ZT est alors égale à :

$$ZT = \frac{\alpha^2 T}{\rho \lambda}$$

La résistivité électrique est déterminée en utilisant la méthode classique de Van Der Pauw (dite 4 pointes) ; le coefficient de Seebeck est déterminé en mesurant directement la tension émise par l'échantillon soumis à un gradient de température ; la conductivité thermique est déterminée directement à l'aide d'un appareil utilisant la technologie de source plane transitoire.
Toutes les mesures sont réalisées à une température de 25°C.
Les résultats de ces mesures sont donnés dans le tableau ci-dessous et mettent en évidence que les matériaux 1-3 présentent une figure de mérite supérieure à 0,1.

| Matériau n° | $\rho$ ($10^{-5}\Omega$.m) | $\alpha$ (\|uV.K$^{-1}$\|) | $\lambda$ (W.m$^{-1}$.K$^{-1}$) | ZT |
|---|---|---|---|---|
| 1 | 12 | 155 | 0,36 | 0,17 |
| 2 | 6,3 | 150 | 0, 49 | 0,22 |
| 3 | 28 | 177 | 0,32 | 0,11 |

**Revendications**

1. Matériau composite hybride thermoélectrique comprenant :

   - une matrice polymère ;
   - des charges thermoélectriques sous forme de particules dispersées au sein de la matrice polymère ;

   **caractérisé par le fait que** :

   - le matériau composite hybride est dépourvu de particules métalliques et que les charges thermoélectriques sont des alliages multicomposants semi-conducteurs de type p ou de type n comprenant au moins les éléments Bi et Te ; et
   - la matrice polymère comprend au moins un polymère choisi dans le groupe consistant en le polystyrène (PS), le polychlorure de vinyle (PVC), le polyéthylène (PE), le polyfluorure de vinylidène (PVDF), le poly (methylmethacrylate) (PMMA), le poly vinyl acétate (PVA), le polyimide (PI), le polypropylène (PP), et leurs mélanges et/ou au moins un copolymère et leurs mélanges.

2. Matériau composite hybride selon la revendication 1, **caractérisé par le fait que** les alliages multicomposants semi-conducteurs de type p contiennent au moins les éléments Bi, Sb et Te.

3. Matériau composite hybride selon la revendication 1, **caractérisé par le fait que** les alliages multicomposants semi-conducteurs de type n contiennent au moins les éléments Bi, Te et Se.

4. Matériau composite hybride selon la revendication 1 ou 2, **caractérisé par le fait que** les alliages multicomposants semi-conducteurs de type p sont des alliages de $Bi_uSb_vTe_w$, où u, v et w sont définis par les relations suivantes :

$$50 \leq w \leq 60 \quad et \quad 30 \leq u+v \leq 40.$$

5. Matériau composite hybride selon la revendication 1 ou 3, **caractérisé par le fait que** les alliages multicomposants semi-conducteurs de type n sont des alliages de $Bi_xTe_ySe_z$, où x, y z sont définis par les relations suivantes :

$$30 \leq x \leq 40, \quad et \quad 50 \leq y+z \leq 60$$

6. Matériau composite hybride selon l'une des revendications 1, 2 ou 4, **caractérisé par le fait que** les alliages multicomposants semi-conducteurs de type p sont des alliages de $Bi_8Sb_{32}Te_{60}$.

7. Matériau composite hybride selon l'une des revendications 1, 2 ou 5, **caractérisé par le fait que** les alliages multicomposants semi-conducteurs de type n sont des alliages de $Bi_{40}Te_{42}Se_{18}$.

8. Matériau composite hybride selon l'une des revendications 1 à 7, **caractérisé par le fait que** les alliages multicomposants semi-conducteurs p ou n comprennent en outre un élément dopant D.

9. Matériau composite hybride selon l'une des revendications 1 à 8, **caractérisé par le fait que** le diamètre des particules des charges thermoélectriques est compris entre 50nm et 500$\mu$m.

10. Matériau composite hybride selon l'une des revendications 1 à 9, **caractérisé par le fait que** le pourcentage volumique des particules de charges thermoélectriques est compris entre 10 et 99% du volume total dudit matériau composite hybride.

11. Matériau composite hybride selon l'une des revendications 1 à 10, **caractérisé par le fait qu'**il présente une figure de mérite ZT supérieure à 0,1.

12. Procédé d'obtention du matériau tel que défini selon l'une des revendications 1 à 11 comprenant les étapes suivantes :

(i) synthèse des charges thermoélectriques sous forme de particules;
(ii) mélange des particules obtenues à l'étape (i) avec un polymère choisi dans le groupe consistant en le polystyrène (PS), le polychlorure de vinyle (PVC), le polyéthylène (PE), le polyfluorure de vinylidène (PVDF), le poly (methylmethacrylate) (PMMA), le poly vinyl acétate (PVA), le polyimide (PI), le polypropylène (PP), et leurs mélanges et/ou un copolymère;
(iii) mise en forme du mélange obtenu à l'étape (ii).

13. Procédé d'obtention d'un matériau composite hybride thermoélectrique selon la revendication 12 **caractérisé par le fait que** la mise en forme est effectuée par pressage à chaud et comprend les étapes suivantes :

- introduction du mélange obtenu à l'issue de l'étape (ii) dans une matrice de pressage ;
- montée en température dudit mélange pour atteindre une température T1;
- augmentation de la pression P dans la matrice de pressage ;
- maintien de la température T1 et de la pression P pendant une durée t ;
- descente en température à une température T2 en maintenant la pression P ;
- diminution de la pression jusqu'à la pression atmosphérique ;
- démoulage de la matrice de pressage.

14. Procédé selon l'une des revendications 12 ou 13, **caractérisé par le fait que** la synthèse des charges thermoélectriques sous forme de particules comprend les étapes suivantes :

- mélange d'une quantité donnée des éléments Bi, Sb, Te ou Bi, Te, Se et d'un éventuel dopant D en fonction d'une stoechiométrie visée ;
- traitement thermique du mélange afin d'atteindre la fusion desdits éléments ;
- refroidissement dudit mélange ;
- obtention d'une poudre par broyage ;
- éventuellement recuit des poudres.

15. Utilisation du matériau tel que décrit selon l'une des revendications 1 à 11 ou obtenu selon l'une des revendications 12 à 14 dans des systèmes à effet Peltier et/ou à effet Seebeck.

16. Utilisation selon la revendication 15 dans la réalisation de panneaux composites hybrides thermoélectriques de faible densité de puissance.

**Patentansprüche**

1. Thermoelektrisches Hybrid-Verbundmaterial, umfassend:

- eine Polymer-Matrix,
- thermoelektrische Ladungen in Form von Partikeln, die in der Polymer-Matrix verteilt sind,

**dadurch gekennzeichnet, dass**

- das Hybrid-Verbundmaterial frei von metallischen Partikeln ist, und die thermoelektrischen Ladungen mehrkomponentige Halbleiter-Legierungen vom p-Typ oder n-Typ sind, welche wenigstens die Elemente Bi und Te umfassen, und
- die Polymer-Matrix wenigstens ein Polymer umfasst, das aus der Gruppe ausgewählt ist, welche besteht aus: Polystyren (PS), Polyvinylchlorid (PVC), Polyethylen (PE), Polyvinylidenfluorid (PVDF), Poly(methylmethacrylat) (PMMA), Polyvinylacetat (PVA), Polyimid (PI), Polypropylen (PP) und Mischungen daraus, oder/und wenigstens ein Copolymer und Mischungen daraus.

2. Hybrid-Verbundmaterial nach Anspruch 1,
**dadurch gekennzeichnet, dass** die mehrkomponentigen Halbleiter-Legierungen vom p-Typ wenigstens die Elemente Bi, Sb und Te enthalten.

3. Hybrid-Verbundmaterial nach Anspruch 1,
**dadurch gekennzeichnet, dass** die mehrkomponentigen Halbleiter-Legierungen vom n-Typ wenigstens die Elemente Bi, Te und Se enthalten.

4. Hybrid-Verbundmaterial nach Anspruch 1 oder 2,
   **dadurch gekennzeichnet, dass** die mehrkomponentigen Halbleiter-Legierungen vom p-Typ Legierungen von $Bi_u Sb_v Te_w$ sind, wobei u, v und w durch die folgenden Beziehungen definiert sind:

$$50 \leq w \leq 60 \text{ und } 30 \leq u+v \leq 40.$$

5. Hybrid-Verbundmaterial nach Anspruch 1 oder 3,
   **dadurch gekennzeichnet, dass** die mehrkomponentigen Halbleiter-Legierungen vom n-Typ Legierungen von $Bi_x$-$Te_y Se_z$ sind, wobei x, y und z durch die folgenden Beziehungen definiert sind:

$$30 \leq x \leq 40 \text{ und } 50 \leq y+z \leq 60.$$

6. Hybrid-Verbundmaterial nach einem der Ansprüche 1, 2 oder 4,
   **dadurch gekennzeichnet, dass** die mehrkomponentigen Halbleiter-Legierungen vom p-Typ Legierungen von $Bi_8 Sb_{32} Te_{60}$ sind.

7. Hybrid-Verbundmaterial nach einem der Ansprüche 1, 2 oder 5,
   **dadurch gekennzeichnet, dass** die mehrkomponentigen Halbleiter-Legierungen vom n-Typ Legierungen von $Bi_{40} Te_{42} Se_{18}$ sind.

8. Hybrid-Verbundmaterial nach einem der Ansprüche 1 bis 7,
   **dadurch gekennzeichnet, dass** die mehrkomponentigen Halbleiter-Legierungen vom n-Typ oder p-Typ weiter ein Dotier-Element D umfassen.

9. Hybrid-Verbundmaterial nach einem der Ansprüche 1 bis 8,
   **dadurch gekennzeichnet, dass** der Durchmesser der Partikel der thermoelektrischen Ladungen zwischen 50 nm und 500 $\mu$m liegt.

10. Hybrid-Verbundmaterial nach einem der Ansprüche 1 bis 9,
    **dadurch gekennzeichnet, dass** der Volumen-Anteil der Partikel von thermoelektrischen Ladungen zwischen 10 und 99 % des Gesamtvolumens des Hybrid-Verbundmaterials beträgt.

11. Hybrid-Verbundmaterial nach einem der Ansprüche 1 bis 10,
    **dadurch gekennzeichnet, dass** es eine Güte-Zahl ZT aufweist, die größer als 0,1 ist.

12. Verfahren zum Erhalten des Materials, wie es in einem der Ansprüche 1 bis 11 definiert ist, umfassend die folgenden Schritte:

    (i) Synthese von thermoelektrischen Ladungen in Form von Partikeln,
    (ii) Mischung der im Schritt (i) erhaltenen Partikel mit einem Polymer, das aus der Gruppe ausgewählt ist, welche besteht aus: Polystyren (PS), Polyvinylchlorid (PVC), Polyethylen (PE), Polyvinylidenfluorid (PVDF), Poly(methylmethacrylat) (PMMA), Polyvinylacetat (PVA), Polyimid (PI), Polypropylen (PP) und Mischungen daraus, oder/und ein Copolymer,
    (iii) Formgebung der im Schritt (ii) erhaltenen Mischung.

13. Verfahren zum Erhalten eines thermoelektrischen Hybrid-Verbundmaterials nach Anspruch 12,
    **dadurch gekennzeichnet, dass** die Formgebung durch Warmpressen durchgeführt wird und die folgenden Schritte umfasst:

    - Einleiten der am Ende von Schritt (ii) erhaltenen Mischung in eine Pressform,
    - Temperatur-Erhöhung der Mischung, um eine Temperatur T1 zu erreichen,
    - Erhöhung des Drucks P in der Pressform,
    - Halten der Temperatur T1 und des Drucks P für eine Dauer t,

- Temperatur-Senkung bis zu einer Temperatur T2, wobei der Druck P gehalten wird,
- Verringern des Drucks bis zu dem Atmosphärendruck,
- Entformen aus der Pressform.

**14.** Verfahren nach einem der Ansprüche 12 oder 13,
**dadurch gekennzeichnet, dass** die Synthese der thermoelektrischen Ladungen in Form von Partikeln die folgenden Schritte umfasst:

- Mischung einer gegebenen Menge der Elemente Bi, Sb, Te oder Bi, Te, Se und gegebenenfalls einer Dotierung D in Abhängigkeit von einer anvisierten Stöchiometrie,
- thermische Behandlung der Mischung, um die Verschmelzung der Elemente zu erreichen,
- Abkühlen der Mischung,
- Erhalten eines Pulvers durch Zerkleinerung
- gegebenenfalls Tempern der Pulver.

**15.** Verwendung des Materials, wie es in einem der Ansprüche 1 bis 11 beschrieben oder nach einem der Ansprüche 12 bis 14 erhalten wird, in Systemen mit Peltier-Effekt oder/und Seebeck-Effekt.

**16.** Verwendung nach Anspruch 15 bei der Herstellung von thermoelektrischen Hybrid-Verbundplatten mit niedriger Leistungsdichte.

**Claims**

**1.** Thermoelectric hybrid composite material comprising:

- a polymeric matrix;
- thermoelectric loads in the form of particles dispersed in the polymeric matrix; **characterised by** the fact that:
- the hybrid composite material is free of metal particles and that the thermoelectric loads are multicomponent semiconductor alloys of the p type or of the n type comprising at least the elements Bi and Te; and
- the polymeric matrix comprises at least one polymer selected from the group consisting of polystyrene (PS), polyvinyl chloride (PVC), polyethylene (PE), polyvinylidene fluoride (PVDF), poly(methylmethacrylate) (PMMA), poly vinyl acetate (PVA), polyimide (PI), polypropylene (PP), and mixtures thereof and/or at least one copolymer and mixtures thereof.

**2.** Hybrid composite material according to claim 1, **characterised by** the fact that the multicomponent semiconductor alloys of the p type contain at least the elements Bi, Sb and Te.

**3.** Hybrid composite material according to claim 1, **characterised by** the fact that the multicomponent semiconductor alloys of the n type contain at least the elements Bi, Te and Se.

**4.** Hybrid composite material according to claim 1 or 2, **characterised by** the fact that the multicomponent semiconductor alloys of the p type are alloys of $Bi_uSb_vTe_w$, where u, v and w are defined by the following relationships:

$$50 \leq w \leq 60 \text{ and } 30 \leq u+v \leq 40.$$

**5.** Hybrid composite material according to claim 1 or 3, **characterised by** the fact that the multicomponent semiconductor alloys of the n type are alloys of $Bi_xTe_ySe_z$, where x, y and z are defined by the following relationships:

$$30 \leq x \leq 40, \text{ and } 50 \leq y+z \leq 60$$

**6.** Hybrid composite material according to one of claims 1, 2 or 4, **characterised by** the fact that the multicomponent semiconductor alloys of the p type are alloys of $B_{18}Sb_{32}Te_{60}$.

**7.** Hybrid composite material according to one of claims 1, 2 or 5, **characterised by** the fact that the multicomponent semiconductor alloys of the n type are alloys of $Bi_{40}TC_{42}Se_{18}$.

8. Hybrid composite material according to one of claims 1 to 7, **characterised by** the fact that the multicomponent semiconductor alloys p or n further comprise a dopant element D.

9. Hybrid composite material according to one of claims 1 to 8, **characterised by** the fact that the diameter of the particles of the thermoelectric loads is between 50nm and 500$\mu$m.

10. Hybrid composite material according to one of claims 1 to 9, **characterised by** the fact that the volume percentage of the particles of thermoelectric loads is between 10 and 99% of the total volume of said hybrid composite material.

11. Hybrid composite material according to one of claims 1 to 10, **characterised by** the fact that it has a figure of merit ZT higher than 0.1.

12. Method for obtaining material such as defined according to one of claims 1 to 11 comprising the following steps:

  (i) synthesis of the thermoelectric loads in the form of particles;
  (ii) mixture of the particles obtained in the step (i) with a polymer selected from the group consisting of polystyrene (PS), polyvinyl chloride (PVC), polyethylene (PE), polyvinylidene fluoride (PVDF), poly(methylmethacrylate) (PMMA), poly vinyl acetate (PVA), polyimide (PI), polypropylene (PP), and mixtures thereof and/or a copolymer;
  (iii) forming of the mixture obtained in the step (ii).

13. Method for obtaining a thermoelectric hybrid composite material according to claim 12 **characterised by** the fact that forming is carried out by hot pressing and comprises the following steps:

  - introduction of the mixture obtained at the end of the step (ii) in a press matrix;
  - increasing the temperature of said mixture in order to reach a temperature T1;
  - increasing the pressure P in the press matrix;
  - maintaining the temperature T1 and the pressure P for a duration t;
  - lowering the temperature to a temperature T2 by maintaining pressure P;
  - decreasing the pressure to atmospheric pressure;
  - unmoulding the press matrix.

14. Method according to one of claims 12 or 13, **characterised by** the fact that the synthesis of the thermoelectric loads in the form of particles comprises the following steps:

  - mixing of a given quantity of the elements Bi, Sb, Te or Bi, Te, Se and a possible dopant D according to a target stoechiometry;
  - heat treating the mixture in order to reach the fusion of said elements;
  - cooling said mixture;
  - obtaining a powder by grinding;
  - possibly annealing of powders.

15. Use of the material such as described according to one of claims 1 to 11 or obtained according to one of claims 12 to 14 in Peltier-effect and/or Seebeck-effect systems.

16. Use according to claim 15 in the carrying out of low power density thermoelectric hybrid composite panels.

## RÉFÉRENCES CITÉES DANS LA DESCRIPTION

**Documents brevets cités dans la description**

- US 6710238 B
- US 2008087314 A
- WO 2010117875 A
- JP 8032124 B
- US 6759587 B